Europäisches Patentamt

European Patent Office

Office européen des brevets

(11) Numéro de publication: **0 338 627**
**A1**

## (12) DEMANDE DE BREVET EUROPEEN

(21) Numéro de dépôt: **89200956.4**

(51) Int. Cl.⁴: **H03H 11/04**

(22) Date de dépôt: **17.04.89**

(30) Priorité: **22.04.88 FR 8805374**

(43) Date de publication de la demande:
**25.10.89 Bulletin 89/43**

(84) Etats contractants désignés:
**DE FR GB IT**

(71) Demandeur: **LABORATOIRES
D'ELECTRONIQUE ET DE PHYSIQUE
APPLIQUEE L.E.P.
3, Avenue Descartes
F-94450 Limeil-Brévannes(FR)**

(84) **FR**

Demandeur: **N.V. Philips'
Gloeilampenfabrieken
Groenewoudseweg 1
NL-5621 BA Eindhoven(NL)**

(84) **DE GB IT**

(72) Inventeur: **Deville, Yannick
SOC. CIVILE S.P.I.D. 209, rue de l'Université
F-75007 Paris(FR)**

(74) Mandataire: **Jacquard, Philippe et al
SOCIETE CIVILE S.P.I.D. 209, rue de
l'Université
F-75007 Paris(FR)**

(54) Circuit actif pour hautes et hyper-fréquences.

(57) Circuit actif pour hautes et hyper-fréquences présentant une bonne sélectivité, et une stabilité peu affectée par les dispersions sur les éléments.

Il comporte un bloc (B) comportant un filtre et un amplificateur, et un sommateur (3).

Le bloc (B) présente une fonction de transfert :

avec $Q_0 > 0$, p = variable de Laplace.

FIG. 1

EP 0 338 627 A1

## CIRCUIT ACTIF POUR HAUTES ET HYPER-FREQUENCES

La présente invention a pour objet un circuit actif dans les domaines des hautes et des hyper-fréquences, à fonction de transfert biquadratique, comprenant un bloc comportant un filtre et un amplificateur, et un sommateur pour réaliser la sommation entre le signal de sortie du bloc et un signal d'entrée appliqué à l'entrée du circuit.

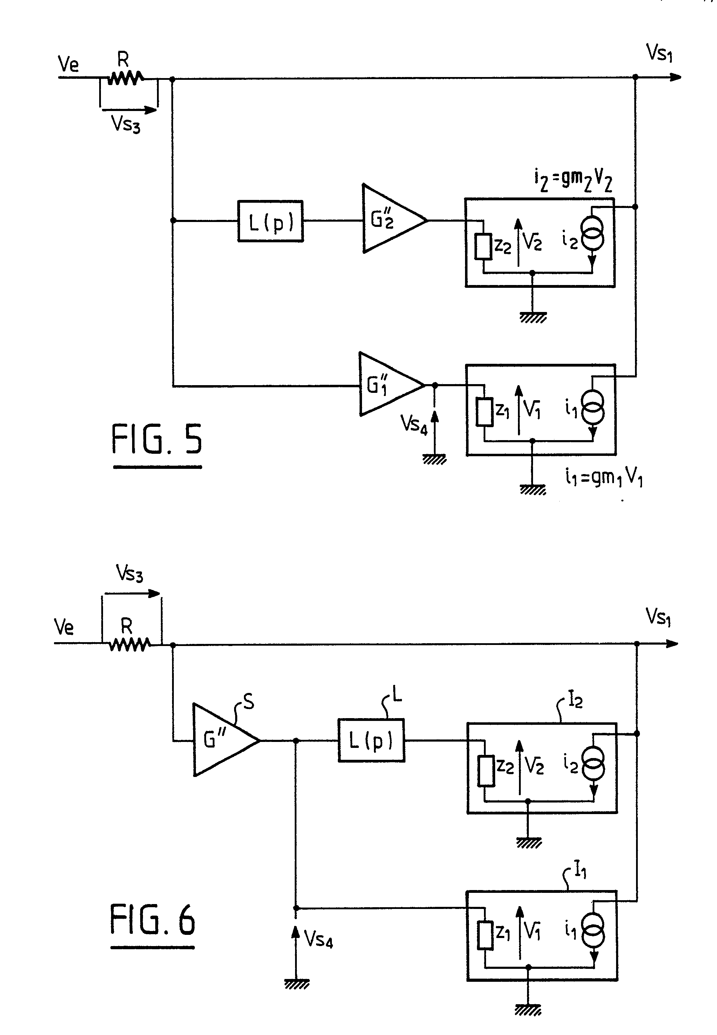

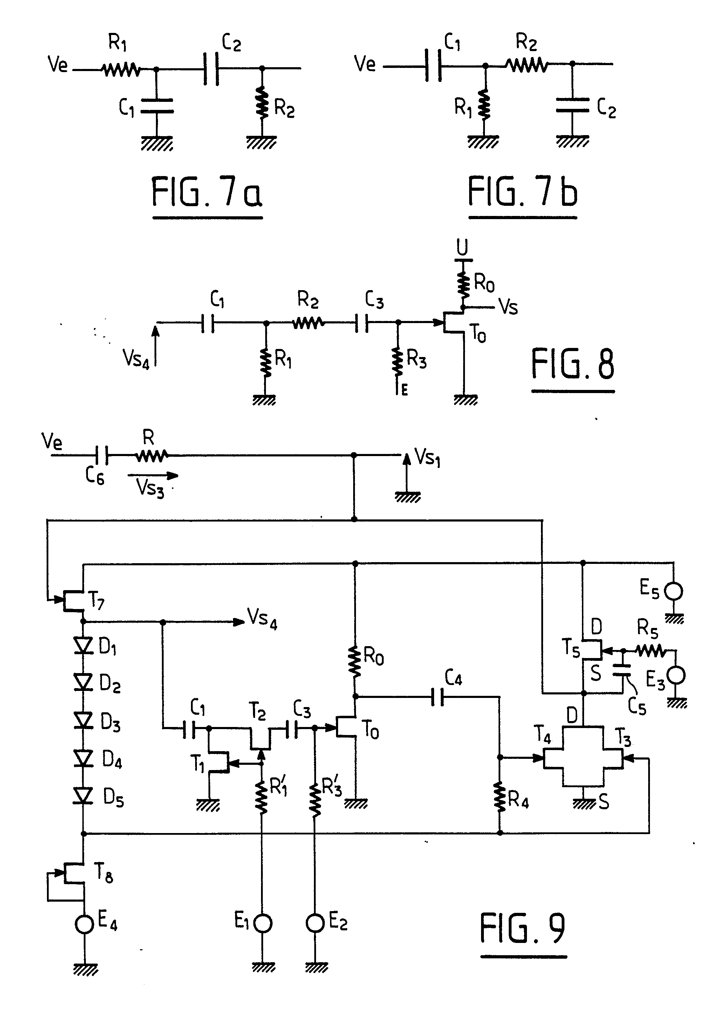

Un tel circuit actif, en l'espèce un filtre, est connu de la publication de J.TOW dans IEEE Spectrum, Decembre 1969 pp.103-107, et intitulée "A step-by-step Active-filter Design". Une réalisation à fonction de transfert biquadratique est représentée à la figure 8, et comprend trois amplificateurs opérationnels en série, cette chaîne étant rétrobouclée. Un quatrième amplificateur opérationnel réalise la sommation de la sortie du premier amplificateur opérationnel et de l'entrée du circuit filtre. En hautes fréquences, le gain des amplificateurs est relativement faible et en outre la chaîne rebouclée est susceptible d'entraîner des oscillations du circuit. Un amplificateur du type passe-bande est représenté à la figure 6 et présente des caractéristiques similaires et donc les mêmes inconvénients.

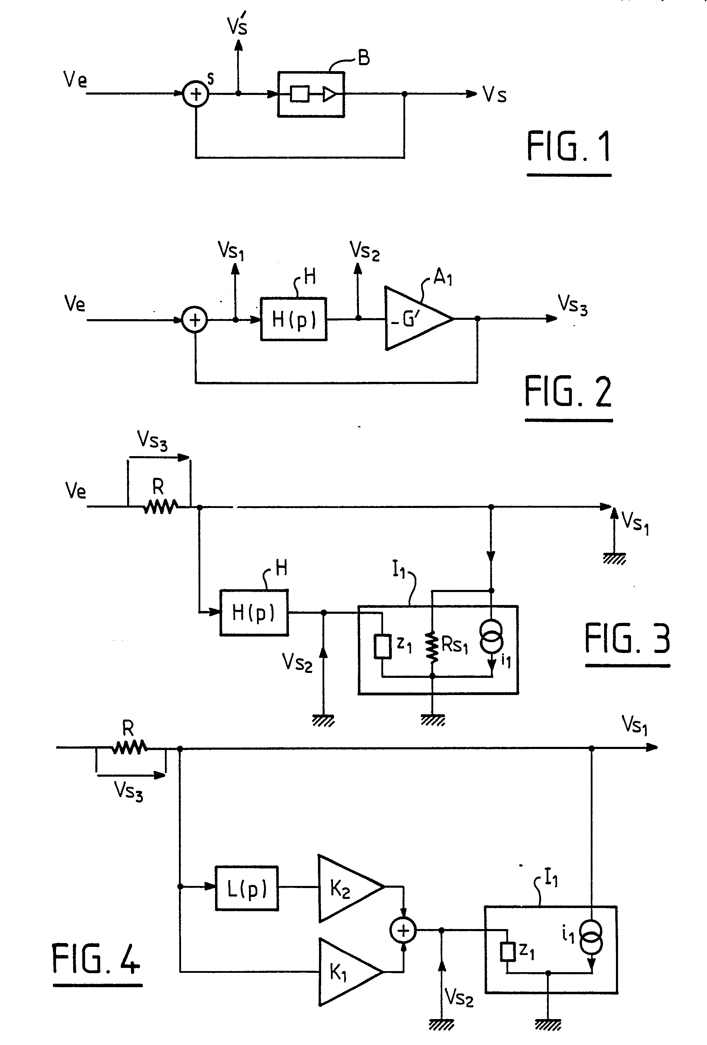

Un filtre est également connu de l'article de J. DAS et al "Twin T feedback filters" Int. J. Electronics 1968 vol 25 n° 5 pp.429-447 fig. 4a. Le filtre présente une fonction de transfert de type coupe-bande, et une sélectivité Q qui vaut

($\frac{k+1}{4}$), k étant le gain de l'amplificateur. Or, tout amplificateur fonctionnant en hautes ou hyper-fréquences, au voisinage de sa fréquence de coupure intrinsèque possède un gain k relativement faible, ce qui conduit dans ce cas à une sélectivité faible du circuit de filtrage.

En outre, la structure pratique proposée concerne un coupe-bande, mais ceci impose des valeurs bien précises des éléments. Si, comme dans le cas des circuits intégrés, les dispersions sur les éléments sont relativement élevées, la cellule est en général d'ordre 3, ce qui entraîne un risque d'oscillations non contrôlées.

De tels filtres sont enfin connus de l'article de R.P SALLEN et E.L. KEY paru dans IRE Trans. Circuit Theory vol CT-2 pp.74-85, Mars 1955 et intitulé "A Practical Method of Designing RC Active Filters". Ces filtres se répartissent en deux classes. Dans la classe A, les filtres sont stables quelles que soient les valeurs des éléments, mais sont peu sélectifs, car la sélectivité maximale vaut $\frac{1}{2}\sqrt{k+1}$.

Dans la classe B, la sélectivité a pour valeur :

$$Q = \frac{\alpha}{\beta - K}$$

$\alpha$ et $\beta$ sont définis par les éléments du filtre et $\alpha$ est faible surtout pour les circuits intégrés où $1<\alpha<10$. De ce fait, une sélectivité Q élevée ne peut être obtenue qu'avec des valeurs de $\beta$-K faibles, ce qui fait que la valeur de Q est très sensible aux dispersions des éléments actifs et passifs, avec un risque d'avoir $\beta$-K<0, c'est-à-dire que le filtre se mette à osciller de manière incontrôlée.

La présente invention propose de remédier à ces inconvénients, en ce sens qu'elle propose un circuit actif présentant une bonne sélectivité, même avec un gain K faible, et une sélectivité améliorée pour des gains K élevés, et dont la stabilité n'est que peu affectée par les dispersions sur les éléments. Sa stabilité est relativement facile à contrôler ce qui fait qu'il se prête à des réalisations soit comme filtre, soit comme oscillateur.

Le circuit de filtrage selon l'invention est dans ce but caractérisé en ce que le bloc présente une fonction de transfert B(p) qui a pour expression :

$$B(p) = -K\frac{(\frac{p}{\omega_1})^2 + \frac{1}{Q_1}(\frac{p}{\omega_1}) + 1}{(\frac{p}{\omega_0})^2 + \frac{1}{Q_0}(\frac{p}{\omega_0}) + 1}$$

avec $Q_0 >0$, et p = variable de Laplace.

Le filtre B(p) présente intrinsèquement une sélectivité égale à Qo qui est en pratique peu élevée (environ de 1/3 à 1/2) mais par contre le circuit actif présente une sélectivité plus élevée qui a pour valeur :

$$Q = \frac{(K + 1)Q_0}{1 + K \dfrac{Q_0}{Q_1}}$$

En outre, le circuit actif se prête, contrairement aux filtres précités, à des réalisations dans lesquelles la fréquence centrale $f_p$ et la sélectivité $Q$ sont réglables séparément.

Lorsque $K$ est faible, on a intérêt pour obtenir les valeurs de $Q$ élevées de choisir $Q_1 < o$.

$$Q = \frac{1}{\dfrac{|Q_1|}{Q_0} - K} \left[ (K + 1)|Q_1| \right]$$

Le terme $(K + 1)|Q_1|$ fournit déjà une valeur de $Q$ relativement élevée.

Le dénominateur permet d'augmenter $Q$, mais le risque d'oscillation dû aux dispersions sur les éléments est peu élevé car, grâce au terme $(K + 1)|Q_1|$, on n'aura pas besoin de rendre le dénominateur très petit.

Lorsque $K$ a une valeur élevée, c'est à dire pour un filtre fonctionnant à des fréquences éloignées de la fréquence intrinsèque de coupure des éléments actifs, on a intérêt à choisir $Q_1 > o$ et le plus grand possible.

Pour $Q_1 \rightarrow +\infty$, on a $Q \rightarrow (k + 1)Qo$, par exemple

$$\frac{(k + 1)}{2}.$$

Dans ce cas, le circuit de filtrage proposé est plus sélectif à gain $k$ égal que celui proposé par J. DAS et al, et également plus stable. Ce circuit de filtrage est également beaucoup plus sélectif que les filtres de classe A décrits par Sallen et Key.

Selon une première variante, l'amplificateur comporte une résistance dont une première borne est connectée à une première source de courant commandée par la tension délivrée par une première sortie du filtre, de telle sorte que la résistance est traversée par ledit courant, et pour réaliser le sommateur, la deuxième borne de la résistance reçoit la tension d'entrée, et l'entrée du filtre est connectée à la première borne de la résistance de manière à recevoir une tension de sortie du filtre.

Cette variante permet, grâce à la mise en oeuvre d'une source de courant commandée en tension, d'obtenir un gain relativement élevé au voisinage des fréquences de coupure intrinsèque des éléments actifs.

Selon un premier mode de réalisation de cette variante, le filtre comporte, connectées en parallèle, une première branche présentant un gain constant, et une deuxième branche présentant une fonction de transfert $L(p)$ a pour expression :

$$L(p) = -K_2 \frac{\dfrac{p}{\omega_0}}{(\dfrac{p}{\omega_0})^2 + \dfrac{1}{Q_0}(\dfrac{p}{\omega_0}) + 1}$$

et le circuit comporte des moyens pour additionner les sorties des deux branches.

Ladite sommation peut alors être avantageusement réalisée en connectant à la première borne de la résistance, un deuxième source de courant commandée en tension par une deuxième sortie du filtre, la première et la deuxième sortie du filtre étant constituées par la sortie respectivement de la première et de la deuxième branche. Le filtre peut comporter à son entrée un deuxième amplificateur à la sortie duquel les première et deuxième branche sont connectées en parallèle.

La fonction de transfert $L(p)$ peut être réalisée en mettant en oeuvre en cascade un premier et un deuxième réseau RC ainsi qu'un étage amplificateur-inverseur, le premier réseau RC étant connecté entre l'entrée et le pôle de mode commun, le deuxième réseau RC étant connecté entre le point milieu du premier réseau RC et le pole de mode commun, le point milieu du deuxième réseau RC constituant la sortie de la deuxième branche, et l'élément du deuxième réseau RC connecté au point milieu du premier réseau RC étant de même nature que l'élément du premier réseau connecté entre son point milieu et le pôle de mode commun. Avantageusement, l'élément du deuxième réseau RC connecté entre son point

3

milieu et le pôle de mode commun est capacitif et est constitué par la capacité de grille d'un premier MESFET constituant l'étage amplificateur-inverseur et recevant sur sa grille une première tension de commande.

Selon un mode de réalisation préféré, les résistances des premier et deuxième réseaux RC sont constituées par respectivement les deuxième et troisième transistors MESFET montés en résistance ajustable et recevant sur leur grille une même deuxième tension de commande. Les première et deuxième sources de courant peuvent être constituées avantageusement par respectivement un quatrième et un cinquième transistor MESFET recevant sur leur grille respectivement un dit signal de sortie du circuit et le signal de sortie du premier transistor MESFET, ainsi que par un sixième transistor MESFET recevant sur sa grille une troisième tension de commande, dont le drain est connecté à une source de tension d'alimentation, et dont la source est connectée au drain commun aux quatrième et cinquième transistors.

Selon une deuxième variante, le bloc comporte un amplificateur à plusieurs entrées, dont la sortie est connectée à l'entrée du filtre, et dont les entrées reçoivent ledit signal d'entrée du circuit et au moins un signal de sortie du filtre.

Le filtre peut comporter, connectées en parallèle, une troisième branche de gain unité et une quatrième branche présentant une fonction de transfert L(p) qui a pour expression :

$$L(p) = -K_3 \frac{\dfrac{p}{\omega_0}}{(\dfrac{p}{\omega_0})^2 + \dfrac{1}{Q_0}(\dfrac{p}{\omega_0}) + 1}$$

et l'amplificateur à plusieurs entrées présente trois entrées, deux d'entre elles étant connectées aux sorties des troisième et quatrième branches.

Selon un mode de réalisation préféré, l'amplificateur à trois entrées comporte un septième, un huitième et un neuvième transistors MESFET dont les grilles constituent lesdites trois entrées, dont les drains sont communs et sont connectés à la source d'un dixième transistor MESFET dont la grille reçoit une quatrième tension de commande et dont le drain est connecté à la source de tension d'alimentation. La quatrième branche du filtre peut avantageusement comporter un troisième et un quatrième réseaux RC, le troisième réseau RC présentant un premier élément capacitif connecté entre le drain commun aux septième, huitième et neuvième transistors MESFET et le point milieu du troisième réseau RC, et un onzième transistor MESFET dont le trajet drain-source est connecté entre le point milieu du troisième réseau RC et le pôle de mode commun, et le quatrième réseau RC présentant un douzième transistor MESFET dont le trajet drain-source est connecté entre les points milieu des troisième et quatrième réseaux RC, l'élément capacitif du quatrième réseau RC étant constitué par la capacité d'entrée d'un treizième transistor MESFET dont la source est connectée au pôle de mode commun, le drain à la grille du septième transistor MESFET, les grilles des onzième et douzième transistors MESFET recevant une cinquième tension de commande et la grille du treizième transistor MESFET reçevant une sixième tension de commande.

L'invention sera mieux comprise à la lecture de la description qui va suivre donnée à titre d'exemple non limitatif, en liaison avec les dessins qui représentent :

- la figure 1, un circuit de filtrage selon l'invention.
- la figure 2, un circuit de filtrage selon la première variante de l'invention.
- les figures 3 à 6 des modes de réalisation de la première variante.
- les figures 7a, 7b et 8 des modes de réalisation d'une branche de filtre.
- la figure 9 un mode de réalisation de la première variante permettant un ajustement des paramètres du circuit de filtrage, les figures 10a et 10b illustrant une courbe de réponse obtenue dans un cas particulier.
- la figure 11, un circuit de filtrage selon la deuxième variante de l'invention.
- les figures 12 et 13, des modes de réalisation de la deuxième variante.
- la figure 14, un mode de réalisation de la deuxième variante permettant un ajustement des paramètres du circuit de filtrage, et les figures 15a et 15b, une courbe de réponse obtenue dans un cas particulier.

Suivant la figure 1, un circuit actif, notamment un filtre, selon l'invention comporte un bloc B comportant un filtre et un amplificateur et un sommateur S pour réaliser la sommation entre le signal de sortie $V_s$ du bloc B et un signal d'entrée $V_e$ appliqué à l'entrée du circuit. Soit $V'_s$ le signal à la sortie du sommateur.

Le bloc B présente une fonction de transfert B(p) de la forme :

$$B(p) = -K \frac{(\frac{p}{\omega_1})^2 + \frac{1}{Q_1}(\frac{p}{\omega_1}) + 1}{(\frac{p}{\omega_0})^2 + \frac{1}{Q_0}(\frac{p}{\omega_0}) + 1}$$

avec $Q_0$ positif, $p$ = variable de Laplace = $j\omega$

Dans la suite de la description, on considère que $\omega_1 \simeq \omega_0$, étant donné que cela correspond à ce qu'on est appelé à utiliser dans les montages réels.

Les deux sorties du montage (à l'entrée et à la sortie du bloc B), donnent les fonctions de transfert suivantes.

$$T(p) = (\frac{V_s}{V_e}) = \frac{B(p)}{1-B(p)} = \frac{-K}{K+1} \frac{(\frac{p}{\omega_p})^2 + \frac{1}{Q_1}(\frac{p}{\omega_p}) + 1}{(\frac{p}{\omega_p})^2 + \frac{1}{Q}(\frac{p}{\omega_p}) + 1}$$

$$T'(p) = (\frac{V'_s}{V_e}) = \frac{1}{1-B(p)} = \frac{1}{K+1} \frac{(\frac{p}{\omega_p})^2 + \frac{1}{Q_0}(\frac{p}{\omega_p}) + 1}{(\frac{p}{\omega_p})^2 + \frac{1}{Q}(\frac{p}{\omega_p}) + 1}$$

$$\text{avec } \omega_p = \omega_1 = \omega_0$$

$$Q = \frac{(K+1) Q_0}{1 + K \frac{Q_0}{Q_1}}$$

A partir d'une cellule B(p) dont la sélectivité $Q_0$ est peu élevée (entre 1/3 et 1/2), on obtient un circuit de filtrage dont les deux sorties ont une sélectivité Q nettement plus élevée.

La sortie $V_s$ correspond à une fonction coupe-bande à condition que $Q<|Q_1|$

La sortie $V'_s$ correspond à une fonction passe-bande à condition que $Q_0<Q$.

Lorsque la fréquence centrale du filtre est assez éloignée de la fréquence de coupure intrinsèque des éléments actifs, la valeur de K peut être élevée et on choisit $Q_1>0$ (et le plus grand possible), ce qui fait que Q est toujours positif et que le filtre est toujours stable. Pour $Q_1$ suffisamment grand, on a :

$Q \simeq (K + 1) Q_0$

Dans ce cas, la structure proposée est plus sélective à K égal que celle décrite par J.DAS et al., et plus stable. Elle est également beaucoup plus sélective que les filtres de classe A décrits par SALLEN et KEY, et beaucoup plus stable que les filtres de classe B selon cette même publication, en raison du fait que l'expression de Q présente un terme multiplicatif $(K + 1)Q_1$ qui diminue d'autant la sensibilité de la valeur de Q aux dispersions sur les éléments.

On obtient donc une amélioration notable des caractéristiques quelle que soit la valeur de K.

Si par ailleurs, on souhaite utiliser le circuit actif comme oscillateur, il suffit de choisir

$$\left|\frac{Q_1}{Q_0}\right| - K < 0$$

avec $Q_1 < 0$ et dans ce cas les propriétés de l'oscillateur sont relativement faciles à contrôler du fait que l'expression du facteur Q présente le terme multiplicatif $(k + 1)|Q_1|$.

En ce qui concerne la sortie $V'_s$, utilisable pour réaliser un circuit de filtrage passe-bande, le gain dans la bande passante est d'autant plus élevé que la valeur de Q est plus grande.

Selon la figure 2, le bloc B(p) est séparé en deux parties, un filtre H étant situé en amont d'un amplificateur $A_1$ de gain $-G'$.

Le filtre H a une fonction de transfert H(p) qui a pour expression :

$$H(p) = G \frac{(\frac{p}{\omega_0})^2 + \frac{1}{Q_1}(\frac{p}{\omega_0}) + 1}{(\frac{p}{\omega_0})^2 + \frac{1}{Q_0}(\frac{p}{\omega_0}) + 1}$$

G est le gain basse fréquence du filtre H, et sa valeur est peu élevée, l'amplification étant assurée par l'amplificateur $A_1$. Le circuit présente une sortie supplémentaire $V_{s2}$ à l'entrée de l'amplificateur $A_1$.

On a :

$$F_1(p) = \frac{V_{s1}}{V_e} = T'(p)$$

$$F_2(p) = \frac{V_{s2}}{V_e} = -\frac{1}{G'} T(p)$$

$$F_3(p) = \frac{V_{s3}}{V_e} = T(p)$$

avec $K = GG'$

Selon la figure 3, une résistance R recevant sur une première borne la tension d'entrée Ve est traversée par le courant $i_1$ d'une source de courant $I_1$ connectée à la deuxième borne de la résistance R et commandée par la tension de sortie du filtre H dont l'entrée est connectée à la deuxième borne de la résistance R. La source de courant $i_1$ a une impédance d'entrée $Z_1$. Le courant $i_1$ a pour valeur $gm_1 V_{s2}$.

Ce montage vérifie les équations :

$V_{s1} = V_e + V_{s3}$

$V_{s2} = H(p) V_{s1}$

$V_{s3} = -Ri_1 = - gm_1 V_{s2}$

Ces équations correspondent bien au cas de la figure 2. Il vient :

$G' = gmR$

L'utilisation d'une source de courant pour réaliser l'amplification permet d'atteindre des gains plus élevés au voisinage des fréquences de coupure intrinsèque des éléments actifs puisqu'il n'y a pas de limitation sur R, ce qui permet d'augmenter le facteur Q sans augmenter la sensibilité aux dispersions, soit de diminuer la sensibilité aux dispersions à Q égal.

Dans les montages pratiques, il existe une résistance de fuite $R_{s1}$ en parallèle sur la source de courant $I_1$. Il vient alors :

$$G' = gm \frac{RR_{s1}}{R+R_{s1}}$$

ce qui impose en pratique, le gain du filtre diminuant, un compromis sur la valeur de R, en rapport avec la valeur de $R_{s1}$.

Selon la figure 4, la cellule H est réalisée sous la forme de deux branches de même entrée et dont les sorties sont additionnées. La première branche comporte une cellule L de fonction de transfert L(p) et un amplificateur de gain $K_2$, et la deuxième branche, un amplificateur de gain $K_1$,

$$\text{avec } L(p) = -K_3 \frac{(\frac{p}{w_0})}{(\frac{p}{w_0})^2 + \frac{1}{Q_0}(\frac{p}{w_0}) + 1}$$

$K_3$ ayant une valeur faible.

Le montage de la figure 4 correspond à celui de la figure 3 avec les conditions suivantes :

$G = K_1$

$$Q_1 = \frac{Q_0}{1 - \frac{K_2 K_3}{K_1} Q_0}$$

Selon la figure 5, la fonction amplification ainsi que la sommation des sorties des deux branches est obtenue à l'aide de deux sources de courant $I_1$ et $I_2$ délivrant des courants $i_1$ et $i_2$ commandés par les tensions de sortie des deux branches de la cellule H. Les étages suiveurs $S_1$ et $S_2$ de gain respectivement $G''_1$ et $G''_2$ ont pour fonction de rendre le montage indépendant des impédances d'entrée $Z_1$ et $Z_2$ des sources de courant $I_1$ et $I_2$.

Il vient :

$i = i_1 + i_2 = (gm_1 G''_1 + gm_2 L_{(p)} G''_2)V_{s1}$

Ce montage est équivalent au précédent (fig. 4) en remplaçant dans les équations $gm_1 K_1$ et $gm_1 K_2$ par respectivement $gm_1 G''_1$ et $gm_2 G''_2$. Notons que la sortie $V_{s2}$ n'est plus accessible, par contre il apparaît une sortie $V_{s4}$ qui ne diffère de $V_{s1}$ que par le gain $G''_1$ et qui a l'avantage d'être une sortie basse impédance.

La figure 6 correspond au cas précédent, avec fusion des deux suiveurs $S_1$ et $S_2$ en un seul suiveur $S$ de gain $G''$ faible. Ce montage est équivalent au précédent en remplaçant $G''_1$ et $G''_2$ par $G''$.

La cellule L peut être réalisée par la mise en cascade d'un filtre passe-bande passif, dont deux exemples de réalisation sont montrés aux figures 7a et 7b, et d'un étage amplificateur-inverseur.

Le filtre passe-bande passif comporte deux réseaux RC en cascade. Entre l'entrée recevant la tension $V_e$ et le pôle de mode commun, sont disposés successivement une résistance $R_1$ et un condensateur $C_1$ - (fig. 7a) ou bien un condensateur $C_1$ et une résistance $R_1$ (fig. 7b). Entre le point milieu du réseau ($R_1$, $C_1$), c'est-à-dire la borne commune à la résistance $R_1$ et au condensateur $C_1$, et le pôle de mode commun, sont disposés successivement un condensateur $C_2$ et une résistance $R_2$ (fig. 7a) ou bien une résistance $R_2$ et un condensateur $C_2$. Le point milieu du réseau ($R_2$, $C_2$), c'est-à-dire la borne commune à la résistance $R_2$ et au condensateur $C_2$, constitue la sortie du filtre passe-bande passif.

Selon la figure 8, l'étage amplificateur-inverseur comporte un transistor MESFET $T_0$, dont la capacité d'entrée de grille est utilisée pour réaliser le condensateur $C_2$. Une résistance $R_3$ en parallèle sur la grille du transistor $T_0$ et un condensateur $C_3$ en série sur celle-ci servent respectivement à la polarisation de la grille par une tension E et au découplage. Une résistance de drain $R_0$ connectée à une tension d'alimentation U sert à la polarisation du drain du transistor $T_0$.

Selon la figure 9, le bloc S de la figure 6 est réalisé par les transistors $T_7$ et $T_8$, les diodes $D_1$ à $D_5$ de décalage de niveau, et la source de tension $E_4$. L'entrée du bloc S est constituée par la grille du transistor $T_7$ et sa sortie (tension $V_s4$), par la source du transistor $T_7$. Les diodes $D_1$ à $D_5$ sont en série et dans le sens direct entre la source du transistor $T_7$ et le drain du transistor $T_8$ dont la grille et la source court-circuitées sont connectées à la source de tension $E_4$, pour former une source de courant. Le filtre L de la figure 6 a des paramètres réglables et dans ce but les résistances $R_1$ et $R_2$ sont constituées par le trajet drain-source de transistors MESFET respectivement $T_1$ et $T_2$ recevant sur leur grille une tension $E_1$ réglable, à travers une résistance de polarisation $R'_1$. De la sorte les transistors $T_1$ et $T_2$ sont utilisés en tant que résistances variables. En outre, le transistor $T_0$ reçoit sur sa grille une tension $E_2$ à travers une résistance de polarisation $R'_3$. Le condensateur $C_1$ reçoit la tension $V_s4$.

Les sources de courant $I_1$ et $I_2$ sont constituées par deux transistors MESFET $T_3$ et $T_4$, dont les drains d'une part, et les sources sont interconnectés, ces dernières étant connectées au pôle de mode commun. La grille du transistor $T_3$ est connectée au drain du transistor $T_8$ qui délivre une ten sion égale à $V_s^4$ diminuée de cinq tensions de diodes, et la grille du transistor $T_4$ est connectée au drain du transistor $T_0$ à travers un condensateur $C_4$ de découplage. Une résistance $R_4$ de valeur élevée assure la polarisation en continu de la grille du transistor $T_4$ du même niveau que celle de $T_3$. Le drain commun aux transistors $T_3$ et $T_4$ est connecté à la source d'un transistor MESFET $T_5$ dont la grille reçoit la tension réglable d'une source de tension $E_3$ à travers une résistance de polarisation $R_5$. Un condensateur $C_5$ est connecté entre la grille et la source de transistor $T_5$ d'où une tension grille-source nulle en alternatif. Le transistor $T_5$ ne sert qu'à évacuer le courant de polarisation de $T_3$ et $T_4$.

Les drains des transistors $T_5$, $T_7$ et $T_0$ sont connectés à une source de tension $E_5$, à travers une résistance de polarisation $R_0$ en ce qui concerne le transistor $T_0$. Notons également, qu'en amont de la résistance R, est disposé un condensateur $C_6$ de découplage.

Le réglage de la fréquence centrale du circuit de filtrage s'effectue en agissant sur la valeur de la tension $E_1$, ce qui modifie simultanément la valeur des résistances $R_1$ et $R_2$.

Le réglage de la valeur Q s'effectue de deux manières : d'une part le réglage de la tension $E_2$ permet d'ajuster grossièrement le facteur $K_3$ de la cellule L, donc la valeur de $Q_1$.

D'autre part, le réglage de la valeur de $E_3$ qui fixe les potentiels communs aux drains des transistors $T_3$ et $T_4$, permet d'ajuster finement les facteurs $gm_1$ et $gm_2$ des sources de courant $I_1$ et $I_2$ et donc le facteur de gain K, donc la valeur de Q. Le réglage de la valeur de Q est plus fin avec le potentiel $E_3$ qu'avec le potentiel $E_2$, car toute variation de $E_2$ se répercute directement sur la tension drain-source du transistor $T_0$, alors qu'une variation de $E_3$ donne une variation plus faible de la tension drain-source des transistors $T_3$ et $T_4$ en raison de la boucle à liaisons continues que contient le montage.

Lorsque le montage est utilisé à des fréquences proches de la fréquence de coupure des éléments actifs, ils apportent des retards de phase qui font que la fréquence centrale $f_p$ du circuit de filtrage est notablement inférieure à la fréquence $f_0$ de la cellule L. Le gain des étages variant notablement avec la fréquence, il faudra, pour modifier la fréquence $f_p$, non seulement agir sur la valeur de la tension $E_1$, mais également sur celles des tensions $E_2$ et $E_3$ pour conserver les mêmes gains à la nouvelle fréquence $f_p$ choisie, donc les mêmes valeurs de $Q_1$ et de K, donc en définitive la même valeur de Q.

- La Demanderesse a réalisé un circuit selon le montage de la figure 9. A titre d'exemple, les valeurs suivantes ont été relevées.

| Cas 1 : | $E_1 = 0V$ | $f_p = 2,39$ GHz |
|---------|------------|------------------|
| Cas 2 : | $E_1 = -1,8V$ | $f_p = 1,13$ GHz |

Dans le cas 1, une valeur de Q assez élevée et positive a été obtenue avec $E_2 = -0,75V$ et $E_3 = 2,5V$, et dans le cas 2 avec $E_2 = -1,95V$ et $E_3 = 2,6V$.

Dans le cas 1, la variation du facteur Q a été évaluée de la manière suivante :

Tableau 1

| $E_1 = 0V$ | $E_3 = 2,5$ V | | | | | |
|------------|---------------|---|---|---|---|---|
| $E_2$ | -0,8 | -0,775 | -0,75 | -0,725 | -0,700V | 0,675V |
| Q | 25 | 32 | 48 | 82 | 390 | <0 |

Tableau 2

| $E_1$ = 0V | $E_2$ = -0,75V | | | | | | |
|---|---|---|---|---|---|---|---|
| $E_3$ | 2,4 | 2,45 | 2,475 | 2,5 | 2,525 | 2,550 | 2,6 |
| Q | 32 | 37 | 42 | 48 | 52 | 60 | 83 |

Il en résulte clairement que le facteur Q est environ quatre fois moins sensible à $E_3$ qu'à $E_2$. $E_3$ permet d'ajuster finement la valeur de Q et d'obtenir des valeurs de l'ordre de 50 à 100 avec une assez bonne précision, ce qui correspond à un gain meilleur que 10 à 15 dB.

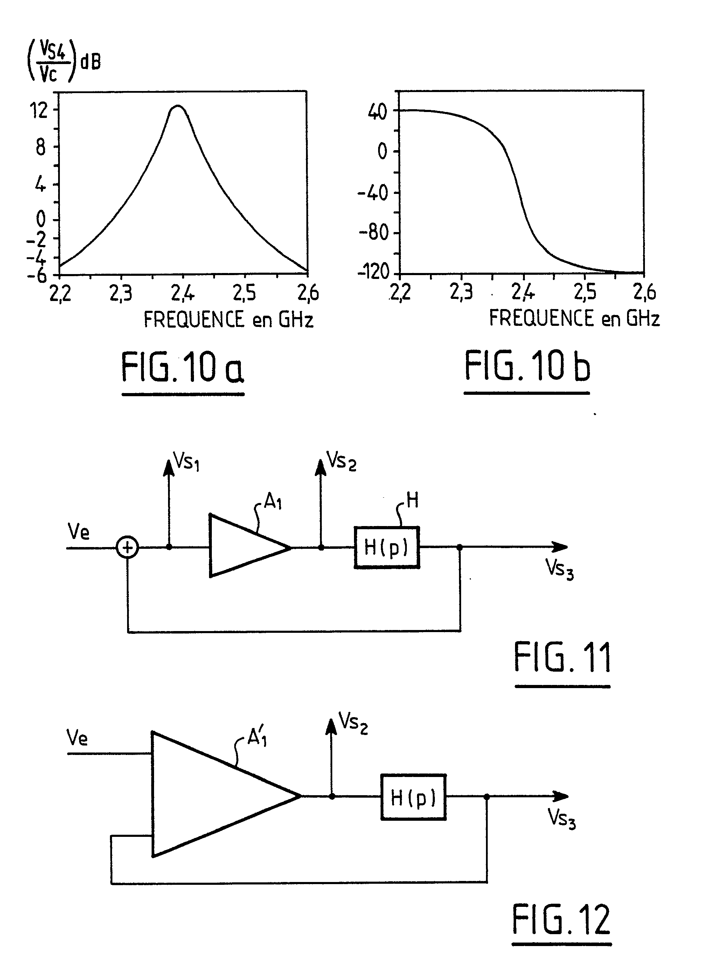

Les figures 10a et 10b donnent les fonctions de transfert pour $E_1$ = 0V, $E_2$ = -0,75V et $E_3$ = 2,5V sont

$$\frac{V_{s4}}{V_e}$$

respectivement en amplitude et en phase.

Selon la figure 11 l'amplificateur $A_1$ est en amont du filtre H de réposne H(p) pour constituer le bloc B de la figure 1.

On obtient aux trois sorties :

$$M_1(p) = \frac{V_{s1}}{V_e} = T'(p)$$

$$M_2(p) = \frac{V_{s2}}{V_e} = G'T'(p)$$

$$M_3(p) = \frac{V_{s3}}{V_e} = T(p)$$

avec $K = GG'$

Selon la figure 12, l'amplificateur-sommateur $A_1$ est à deux entrées de manière à réaliser la sommation entre la tension d'entrée Ve et la tension de sortie $V_{s3}$.

On a en sortie de l'amplificateur $A'_1$.

$V_{s2} = -G'_1 V_e - G'_2 V_{s3}$

On obtient aux sorties :

$$M'_2(p) = \frac{V_{s2}}{V_e} = G'_1 T'(p)$$

$$M'_3(p) = \frac{V_{s3}}{V_e} = \frac{G'_1}{G'_2} T'(p)$$

avec $K = GG'_2$

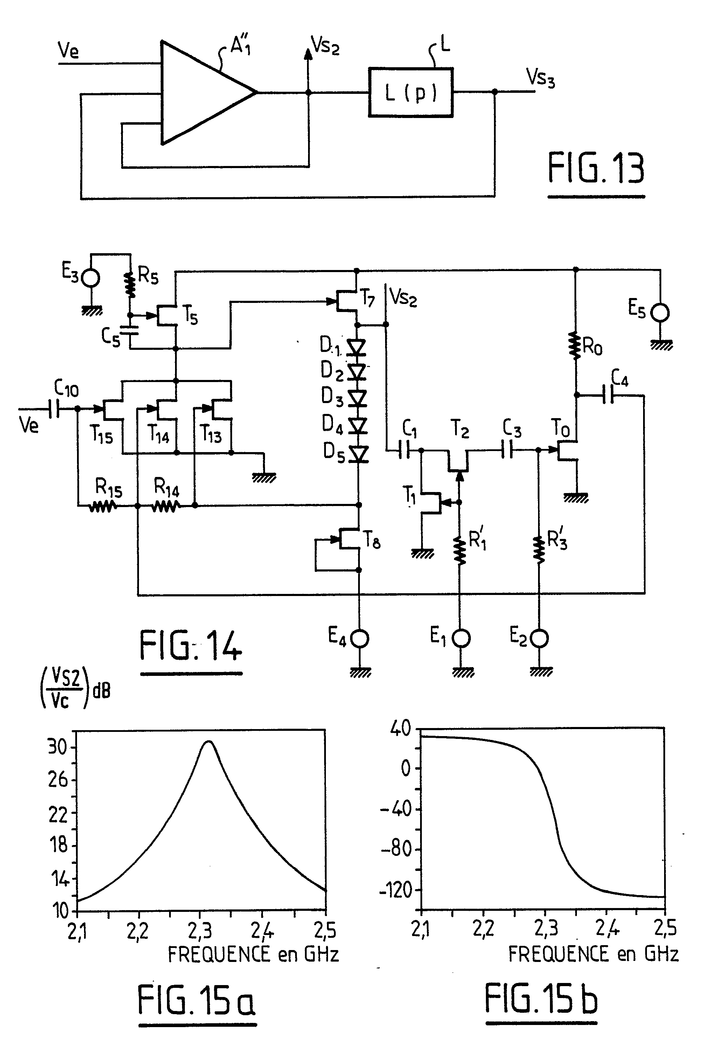

Selon la figure 13, l'amplificateur, sommateur $A''_1$ est à trois entrées, le filtre H ayant été remplacé par un filtre L à deux branches parallèle, une de réponse L(p), et l'autre de gain unité (voir fig. 6 par exemple). La sortie de l'amplificateur $A''_1$ attaque l'entrée du filtre L(p).

Les trois entrées de l'amplificateur $A''_1$ reçoivent la tension d'entrée Ve, la tension de sortie $V_{s2}$ de l'amplificateur $A''_1$, et la tension de sortie $V_{s3}$ du filtre L. On a en sortie de l'amplificateur $A''_1$ :

9

$V_{s2} = -G'_3 V_e - G'_4 V_{s3} - G'_5 V_{s2}$. Ce schéma vérifie les mêmes équations que précédemment en remplaçant $G'_1$, $G'_2 K_2$ et $G'_2 K_1$ respectivement par $G'_3$, $G'_4$ et $G'_5$.

Selon la figure 14, le filtre L est constitué de la même façon qu'à la figure 9 (transistors $T_1$, $T_2$, $T_0$, condensateurs $C_1$, $C_3$ et $C_4$, résistances $R'_1$ et $R'_3$, sources de tension $E_1$ et $E_2$). L'amplificateur de tension $A''_1$ possède trois entrées. A cet effet, le drain commun à trois transistors $T_{13}$, $T_{14}$ et $T_{15}$ dont les sources sont reliées au pôle de mode commun est connecté à la source d'un transistor $T_5$ monté comme dans le cas de la figure 9 (condensateur $C_5$ entre grille et source, résistance $R_5$, source de tension de grille $E_3$).

La grille du transistor $T_{15}$ reçoit l'entrée Ve à travers un condensateur de découplage $C_{10}$. La grille du transistor $T_{14}$ est connectée au drain du transistor $T_0$ à travers le condensateur $C_4$ de découplage, et la grille du transistor $T_{13}$ reçoit la tension de drain du transistor $T_8$ qui forme une source de courant pour forcer une tension de décalage de niveau dans les diodes $D_1$ à $D_5$ montées en direct par la source du transistor $T_7$ (montage suiveur) comme dans le cas de la figure 9. La grille du transistor $T_7$ est connectée au drain commun aux transistors $T_{13}$ à $T_{15}$, et sa source, au condensateur $C_1$. Des résistances $R_{14}$ et $R_{15}$ pontent les grilles des transistors $T_{13}$ et $T_{14}$, et $T_{14}$ et $T_{15}$ respectivement, de manière à assurer leur polarisation en continu au même niveau.

Le réglage de la valeur de Q s'effectue de la même manière que dans le cas de la figure 2.

A titre indicatif, dans un exemple de réalisation, la Demanderesse a obtenu les valeurs suivantes :

| Cas 1 : | $E_1 = 0V$ | $f_p = 2{,}32$ GHz |
|---------|-----------|---------------------|
| Cas 2 : | $E_1 = 1{,}8V$ | $f_p = 1{,}10$ GHz |

Dans le cas 1, une valeur de Q assez élevée et positive a été obtenue avec $E_2 = -0{,}8V$ et $E_3 = 2{,}5V$, et dans le cas 2 avec $E_2 = -1{,}95V$ et $E_3 = 2{,}5V$.

Dans le cas 1, la variation du facteur Q a été évaluée de la manière suivante :

Tableau 1

| $E_1 =$ 0V | $E_3 = 2{,}5$ V | | | |
|------------|------------------|--------|--------|--------|
| $E_2$ | -0,825 | -0,8 | -0,775 | -0,75 |
| Q | 34 | 51 | 105 | <0 |

Tableau 2

| $E_1 =$ 0V | $E_2 = -0{,}75V$ | | | | | | |
|------------|-------------------|------|-------|-------|-------|------|-----|
| $E_3$ | 2,4 | 2,45 | 2,475 | 2,500 | 2,525 | 2,55 | 2,6 |
| Q | 33 | 40 | 46 | 51 | 61 | 71 | 105 |

Q est environ quatre fois plus sensible à $E_2$ qu'à $E_3$, comme d'ailleurs dans le cas de la figure 9.

Pour des valeurs de Q de l'ordre de 50, le gain du circuit de filtrage est de l'ordre de 30 dB, ce qui est meilleur que dans le cas de la figure 9. A titre d'exemple, une fonction de transfert est donnée aux figures 15a et 15b avec $E_1 = 0V$, $E_2 = -0{,}8V$ et $E_3 = 2{,}5V$, soit

$$\frac{V_{s2}}{Ve}$$

respectivement en amplitude, et en phase $+180°$.

**Revendications**

1. Circuit actif dans les domaines des hautes et hyper-fréquences, à fonction de transfert biquadratique, comprenant un bloc (B) comportant un filtre et un amplificateur, et un sommateur (s) pour réaliser la sommation entre le signal de sortie du bloc (B) et un signal d'entrée ($V_E$) appliqué à l'entrée (E) du circuit, caractérisé en ce que le bloc B présente une fonction de transfert B(p) qui a pour expression :

$$B(p) = -K \frac{(\frac{p}{\omega_1})^2 + \frac{1}{Q_1}(\frac{p}{\omega_1}) + 1}{(\frac{p}{\omega_0})^2 + \frac{1}{Q_0}(\frac{p}{\omega_0}) + 1}$$

avec $Q_0 > 0$, p = variable de Laplace.

2. Circuit selon la revendication 1 caractérisé en ce que l'amplificateur comporte une résistance (R) dont une première borne est connectée à une première source de courant commandée par la tension délivrée par une première sortie du filtre, de telle sorte que la résistance (R) est traversée par ledit courant, en ce que, pour réaliser le sommateur (S), la deuxième borne de la résistance (R) reçoit la tension d'entrée ($V_E$), et en ce que l'entrée du filtre (H) est connectée à la première borne de la résistance (R), de manière à recevoir une tension de sortie du circuit.

3. Circuit selon la revendication 2, caractérisé en ce que le filtre (H) comporte, connectées en parallèle, une première branche présentant un gain ($K_1$) constant en fonction de la fréquence, et une deuxième branche présentant une fonction de transfert L(p) qui a pour expression :

$$L(p) = -K_2 \frac{\frac{p}{\omega_0}}{(\frac{p}{\omega_0})^2 + \frac{1}{Q_0}(\frac{p}{\omega_0}) + 1}$$

et en ce que le circuit comporte des moyens pour additionner les sorties des deux branches.

4. Circuit selon la revendication 3 caractérisé en ce que l'amplificateur comporte également une deuxième source de courant connectée à la première borne de la résistance (R) et commandée en tension par une deuxième sortie du filtre, en ce que la première et la deuxième sortie du filtre sont constituées par la sortie respectivement de la première et de la deuxième branche.

5. Circuit selon la revendication 4 caractérisé en ce que le filtre comporte à son entrée un deuxième amplificateur à la sortie duquel lesdites première et deuxième branches sont connectées en parallèle.

6. Circuit selon une des revendications 3 à 5 caractérisé en ce que le filtre comporte, pour réaliser la fonction de transfert L(p), un premier et un deuxième réseau RC et un étage amplificateur-inverseur en cascade, le premier réseau RC étant connecté entre l'entrée du filtre et le pôle de mode commun, le deuxième réseau RC étant connecté entre le point milieu du premier réseau RC et le pôle de mode commun, le point milieu du deuxième réseau RC constituant la sortie de la deuxième branche, et en ce que l'élément du deuxième réseau RC connecté au point milieu du premier réseau RC est de même nature que l'élément du premier réseau connecté entre son point milieu et le pôle de mode commun.

7. Circuit selon la revendication 6 caractérisé en ce que l'élément du deuxième réseau RC connecté entre son point milieu et le pôle de mode commun est capacitif, et est constitué par la capacité de grille d'un premier transistor MESFET constituant l'étage amplificateur inverseur et recevant sur sa grille une première tension de commande.

8. Circuit selon la revendication 7, caractérisé en ce que les résistances des premier et deuxième réseaux RC sont constituées par respectivement des deuxième et troisième transistors MESFET montés en résistance ajustable et recevant sur leur grille une même deuxième tension de commande.

9. Circuit selon une des revendications 7 ou 8 caractérisé en ce que les première et deuxième source de courant sont constituées par respectivement un quatrième et un cinquième transistors MESFET, recevant sur leur grille respectivement un dit signal de sortie du circuit et le signal de sortie du premier transistor MESFET, ainsi que par un sixième transistor MESFET recevant sur sa grille une troisième tension de commande, dont le drain est connecté à une source de tension d'alimentation, et dont la source est connectée au drain commun aux quatrième et cinquième ($T_2$) transistors.

10. Circuit selon la revendication 1, caractérisé en ce que le bloc (B) comporte un amplificateur à plusieurs entrées, dont la sortie est connectée à l'entrée du filtre et dont les entrées sont agencées pour recevoir ledit signal d'entrée du circuit et au moins un signal de sortie du filtre (H).

11. Circuit selon la revendication 10, caractérisé en ce que le filtre (H) comporte, connectées en parallèle, une troisième branche de gain unité, et une quatrième branche présentant une fonction de transfert L(p) qui a pour expression :

$$L(p) = -K_3 \frac{\cdot \dfrac{p}{\omega_0}}{\left(\dfrac{p}{\omega_0}\right)^2 + \dfrac{1}{Q_0}\left(\dfrac{p}{\omega_0}\right) + 1}$$

et en ce que l'amplificateur à plusieurs entrées présente trois entrées deux d'entre elles étant connectées aux sorties des troisième et quatrième branches.

12. Circuit selon la revendication 11 caractérisé en ce que l'amplificateur à trois entrées comporte un septième, un huitième et un neuvième transistors MESFET dont les grilles constituent lesdites trois entrées, dont les drains sont communs et sont connectés à la source d'un dixième transistor MESFET dont la grille reçoit une quatrième tension de commande et dont le drain est connecté à la source de tension d'alimentation.

13. Circuit selon la revendication 12, caractérisé en ce que la quatrième branche du filtre comporte un troisième et un quatrième réseaux RC, le troisième réseau RC présentant un transistor MESFET et le point milieu du troisième réseau RC et un onzième transistor MESFET dont le trajet drain-source est connecté entre le point milieu du troisième réseau RC et le pôle de mode commun, et le quatrième réseau RC présentant un douzième transistor MESFET dont le trajet drain-source est connecté entre les points milieu des troisième et quatrième réseaux RC, l'élément capacitif du quatrième réseau RC étant constitué par la capacité de grille d'un treizième transistor MESFET dont la source est connectée au pôle de mode commun, le drain à la grille du septième transistor MESFET, en ce que les grilles des onzième et douzième transistors MESFET reçoivent une cinquième tension de commande et en ce que la grille du treizième transistor MESFET reçoit une sixième tension de commande.

Ve ——→ ⊕ s ——→ Vs'

B

——→ Vs

## FIG. 1

Ve ——→ ⊕ ——→ $V_{S_1}$ ——→ $H(p)$ ——→ $V_{S_2}$ ——→ $-G'$ ($A_1$) ——→ $V_{S_3}$

## FIG. 2

$V_{S_3}$

Ve ——→ R ——→ $V_{S_1}$

$H(p)$ ——→ $V_{S_2}$

$I_1$ : $z_1$, $R_{S_1}$, $i_1$

## FIG. 3

R ——→ $V_{S_1}$

$V_{S_3}$

$L(p)$ ——→ $K_2$ ——→ ⊕ ——→ $I_1$ : $z_1$, $i_1$

$K_1$

$V_{S_2}$

## FIG. 4

EP 0 338 627 A1

FIG. 5

FIG. 6

2 - V - PHF 88-527

FIG. 7 a

FIG. 7 b

FIG. 8

FIG. 9

3 - V - PHF 88-527

FIG. 10 a

FIG. 10 b

FIG. 11

FIG. 12

FIG.13

FIG.14

$\left(\dfrac{V_{S2}}{V_c}\right)$dB

FREQUENCE en GHz

FIG.15a

FREQUENCE en GHz

FIG.15b

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | DE-B-1 262 466 (STANDARD ELEKTRIK LORENZ) <br> * Figure 3; colonne 3, ligne 53 - colonne 5, ligne 34; figure 1 * | 1 | H 03 H 11/04 |
| A | --- | 6 | |
| Y | IEEE TRANSACTIONS ON CIRCUITS AND SYSTEMS, vol. CAS-31, no. 4, avril 1984, pages 398-402, IEEE, New York, US; S. NATARAJAN: "A simple predistortion technique for active filters" <br> * Pages 398-399, paragraphe II: "Predistortion technique" * | 1 | |
| A | ELECTRONICS LETTERS, vol. 19, no. 16, 4 août 1983, pages 639-640, Londres, GB; M. BIEY: "Design of lowpass two-section generalised FLF active filters" <br> * En entier * | 1 | |
| A | FR-A-2 330 204 (SUNDSTRAND) <br> * Figure 9; page 14, lignes 30-35 * | 2 | **DOMAINES TECHNIQUES RECHERCHES (Int. Cl.4)** <br> H 03 H |
| A | ELECTRONICS LETTERS, vol. 8, no. 2, 28 janvier 1972, pages 43-44, Londres, GB; F. CAPPARELLI et al.: "Active bandpass network with only resistors as passive elements" <br> * En entier * | 3 | |
| A | US-A-4 242 642 (K.R. LAKER) <br> * En entier * | 1 | |

Le présent rapport a été établi pour toutes les revendications

| Lieu de la recherche | Date d'achèvement de la recherche | Examinateur |
|---|---|---|
| LA HAYE | 28-07-1989 | COPPIETERS C. |

EPO FORM 1503 03.82 (P0402)